# FASCICULE DE BREVET EUROPEEN

(11) **EP 3 035 534 B1**
(45) Date de publication et mention de la délivrance du brevet: **04.04.2018**
(21) Numéro de dépôt: 15200021.2
(22) Date de dépôt: 15.12.2015
(51) Int. Cl.: H03K 17/969

(54) **CLAVIER A FIABILITE AMELIOREE**
TASTATUR MIT VERBESSERTER ZUVERLÄSSIGKEIT
KEYBOARD WITH IMPROVED RELIABILITY

(30) Priorité: 17.12.2014 FR 1402876
(43) Date de publication de la demande: 22.06.2016
(73) Titulaire: THALES, 92400 Courbevoie (FR)
(72) Inventeur: TORAILLE, Vincent, 41100 VENDOME (FR); BELLON, Jacques, 41100 VENDOME (FR)
(74) Mandataire: Collet, Alain

(56) Documents cités:
- WO-A1-2005/125011
- DE-A1- 19 856 008
- FR-A1- 2 521 330
- GB-A- 2 074 428
- GB-A- 2 409 515
- JP-A- 2004 214 059
- US-A- 5 975 711
- US-A1- 2003 052 257
- US-A1- 2003 193 421
- US-A1- 2010 326 803
- US-B1- 6 741 189

## Description

L'invention concerne un clavier dont la fiabilité est améliorée. Les claviers sont présents dans de nombreux équipements électroniques. Ils sont utilisés pour qu'un utilisateur puisse saisir des données.

Des claviers connus comprennent des touches destinées à être manoeuvrées par un utilisateur. La manoeuvre d'une touche entraine celle d'un interrupteur permettant de réaliser une connexion électrique entre deux points afin de faire transiter ou non un signal électrique en fonction de l'appui sur la touche. L'interrupteur comprend par exemple un dôme métallique solidaire d'un circuit imprimé. Le dôme est destiné à s'effondrer sous l'effet d'un appui sur la touche. En s'effondrant, le dôme crée un contact électrique sur le circuit imprimé.

Ce type de clavier génère de nombreuses contraintes sur l'équipement. Tout d'abord, la durée de vie du clavier est limitée par la mécanique des touches et des interrupteurs associés. Les pièces en mouvement et leur fixation peuvent atteindre leur limite en fatigue. Pour atteindre une durée de vie souhaitée, on peut être amené à surdimensionner certains composants, ce qui entraine des surcoûts et peut gêner dans une recherche de miniaturisation.

Le document US6741189 B1 décrit un clavier optique selon l'état de la technique.

L'invention apporte une solution à ce problème en proposant un clavier beaucoup plus simple à réaliser. Le clavier est réalisé autour d'un guide d'onde optique remplissant de nombreuses fonctions comme notamment de découpler le mouvement de la touche de la formation d'un signal représentatif du mouvement de la touche.

A cet effet, l'invention a pour objet un clavier comprenant :
- plusieurs touches destinées à être manoeuvrées par un utilisateur, la manoeuvre des touches permettant de former pour chaque touche un signal représentatif de sa manoeuvre,
- un guide d'onde plan possédant une première et une seconde faces externes, une onde lumineuse pouvant se réfléchir totalement entre les deux faces, la première face du guide d'onde comprenant une zone altérée de façon à ce qu'une partie de l'onde sorte du guide d'onde par la zone altérée pour rétroéclairer le clavier,
- associé à chaque touche, un plongeur apte à être déplacé par la touche correspondante entre deux positions, l'une en contact avec la première face du guide d'onde et l'autre à distance de la première face, le contact du plongeur sur la première face entrainant une frustration locale de la réflexion de l'onde dans le guide d'onde,
- sous chacun des plongeurs un capteur disposé dans un espace libre délimité par la seconde face, le capteur étant configuré pour détecter la frustration de la réflexion, le capteur formant le signal représentatif respectif.

La présence d'un guide d'onde optique est bien entendu utilisée pour former les signaux représentatifs du mouvement des touches. Le guide d'onde permet également le rétroéclairage du clavier. Il permet aussi de séparer les touches des capteurs ou plus précisément d'isoler physiquement deux parties du clavier :
- les parties mécaniques du clavier se déplaçant lors de la manoeuvre des touches,
- la partie du clavier assurant la formation des signaux représentatifs du mouvement des touches.

Cet isolement physique permet de protéger la partie assurant la formation des signaux de poussières ou de liquides pouvant polluer les touches.

Par ailleurs, la protection des claviers vis-à-vis des perturbations électromagnétiques peut poser des problèmes. En effet, dans des claviers classiques, les signaux électriques transitant par les interrupteurs peuvent subir des perturbations ou perturber d'autres équipements. La présence des parties mobiles des claviers peut rendre difficile la réalisation d'écrans de blindage permettant d'isoler les signaux de l'environnement extérieur. La présence du guide d'onde permet de résoudre facilement ce problème. A cet effet, le clavier comprend avantageusement, un écran de blindage électrique disposé sur une des faces du guide d'onde, l'écran de blindage étant transparent à l'onde propagée dans la guide d'onde.

Avantageusement, le clavier comprend au moins un cache permettant de protéger chacun des capteurs d'une onde parasite ne provenant pas de la frustration entrainée par le contact du plongeur associé au capteur.

Le cache peut être formé par un masque opaque à l'onde se propageant dans le guide d'onde, le masque recouvrant la seconde face à l'exception d'un trou centré en regard d'une zone destinée à recevoir le contact du plongeur sur la première face.

La zone altérée peut comprendre des moyens de focalisation de la lumière extraite par la première face autour d'une direction perpendiculaire au plan du guide d'onde.

Le clavier peut comprendre une première et une seconde sources d'onde se propageant dans le guide d'onde et émettant chacune dans une bande de longueur d'onde, les deux bandes étant distinctes. Le capteur est alors configuré pour détecter une onde de la bande de la première source et la bande de la seconde source est utilisée pour sortir du guide d'onde par la zone altérée.

Avantageusement, le clavier comprend une source de lumière pilotée par le signal représentatif et permettant un retour d'information vers l'utilisateur fonction du contact du plongeur avec la première face du guide d'onde.

La source de lumière permettant le retour d'information peut être disposée de façon à émettre de la lumière perpendiculairement au guide d'onde en le traversant.

La source de lumière permettant le retour d'information peut émettre dans une bande de longueur d'onde distincte de celle pour laquelle le capteur est configuré.

L'invention sera mieux comprise et d'autres avantages apparaîtront à la lecture de la description détaillée d'un mode de réalisation donné à titre d'exemple, description illustrée par le dessin joint dans lequel :
la figure 1 représente schématiquement en coupe un exemple de clavier conforme à l'invention ;
la figure 2 représente une simulation d'une onde rétrodiffusée pour des appuis simultanés sur plusieurs touches du clavier ;
la figure 3 représente schématiquement le clavier en perspective.

Par souci de clarté, les mêmes éléments porteront les mêmes repères dans les différentes figures.

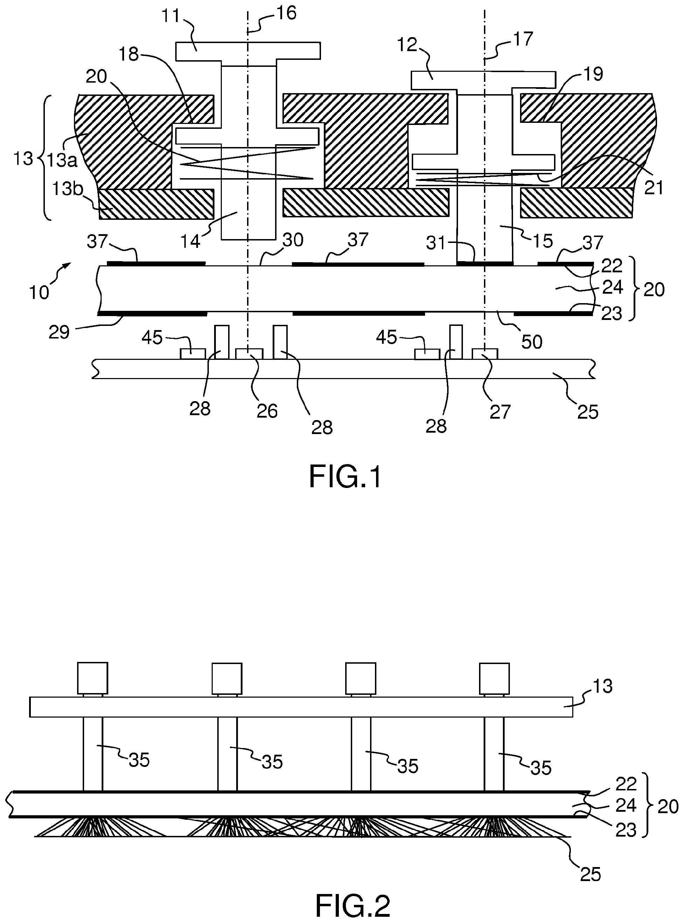

La figure 1 représente un clavier 10 comprenant deux touches 11 et 12. Dans la pratique, un clavier conforme à l'invention peut comprendre un plus grand nombre de touches, ce qui est par exemple le cas dans un clavier permettant la saisie de caractères alphanumériques. A l'inverse l'invention peut être mise en oeuvre dans un clavier ne possédant qu'une seule touche.

En revenant à l'exemple représenté, les touches 11 et 12 sont mobiles en translation par rapport à un support 13 par exemple plan et fixé à un équipement électronique. Solidaire de chaque touche 11 et 12, un plongeur, respectivement 14 et 15 suit le mouvement de translation de la touche considérée. Dans la pratique la touche et le plongeur qui lui est associé peuvent être formés par la même pièce mécanique ou par deux pièces mécaniques distinctes fixées l'une à l'autre. On peut cependant distinguer la fonction de la touche qui est de recevoir l'appui d'un utilisateur et la fonction du plongeur qui est de transmettre cet appui. Les plongeurs 14 et 15 peuvent se déplacer en translation chacun selon un axe, respectivement 16 et 17, ces axes étant parallèles entre eux et perpendiculaires au support 13. Sur la figure 1, les axes 16 et 17 sont représentés verticalement et le déplacement des touches 11 et 12 se fait de haut en bas le long de leur axe respectif. Le déplacement de chacune des touches 11 et 12 est limité vers le haut par une butée, respectivement 18 et 19, formée dans le support 13. Chacun des plongeurs 14 et 15 prend appui contre sa butée respective. Un ressort de rappel, respectivement 20 et 21 peut repousser le plongeur vers sa butée respective. Dans cette position, en appui contre sa butée, la touche et son plongeur sont dans une position de repos, c'est-à-dire une position non activée par un utilisateur. A l'inverse, lorsque l'utilisateur presse sur une des touches 11 ou 12, au moyen d'un appui vertical, le plongeur correspondant quitte son appui contre sa butée et enfonce le ressort de rappel associé. Le support 13 peut être formé de deux pièces mécaniques 13a et 13b fixées entre elles afin de permettre le montage du plongeur et du ressort correspondant.

Dans l'exemple représenté, le ressort de rappel 20 ou 21 exerce sur le plongeur correspondant 14 ou 15 une force proportionnelle à son déplacement. Il est possible de prévoir un retour tactile vers l'utilisateur non proportionnel, présentant par exemple une courbe effort/déplacement présentant un maximum. Ce type de courbe peut être par exemple obtenu au moyen d'un « point dur » dans le déplacement du plongeur. Ce point dur peut comprendre une came réalisée sur le plongeur. Un suiveur de came comme par exemple une bille, pouvant se déplacer horizontalement par rapport au support 13, est maintenue en appui contre la came au moyen d'un ressort. La forme de la came permet de définir la courbe effort/déplacement souhaitée.

Le clavier 10 comprend un guide d'onde 20 plan sensiblement perpendiculaire aux axes 16 et 17. Le guide d'onde 20 permet de guider une onde électromagnétique, comme par exemple une onde lumineuse, dans une couche centrale 24, limitée par deux faces externes 22 et 23. L'indice de réfraction de la couche centrale 24 est supérieur à celui du milieu dans lequel est placé le guide d'onde 20, comme notamment de l'air. On obtient ainsi une réflexion totale de l'onde se propageant dans la couche centrale 24 sur les deux faces externes 22 et 23. Le guide d'onde 20 est par exemple réalisé en verre ou en poly méthacrylate de méthyle connu sous le nom abrégé PMMA, provenant de son abréviation anglo-saxonne : « Polymethyl methacrylate ».

Le plongeur 14 ou 15 peut se déplacer entre deux positions, l'une en contact avec la face 22 et l'autre à distance de la face 22 et en appui contre sa butée 18 ou 19. Sur la figure 1, le plongeur 14 est représenté à distance de la face 22 et le plongeur 15 est représenté en contact avec la face 22. Le contact du plongeur 15 sur la face 22 entraine une frustration locale de la réflexion de l'onde dans le guide 20. Cette frustration entraine une rétrodiffusion de l'onde qui traverse le guide 20 perpendiculairement à son plan. Une partie de l'onde traverse alors la face 23 lorsque le plongeur 15 est en contact avec la face 22. En l'absence de contact entre le plongeur et la face 22, aucune frustration ne se produit et la réflexion de l'onde est totale sur les deux faces 22 et 23. En disposant sous le guide d'onde 20, un capteur sous chacun des plongeurs 14 et 15, il est possible de détecter la frustration et par conséquent le contact du plongeur considéré sur la face 22. Un plongeur dont l'indice de réfraction est supérieur à celui de l'air frustre cette réflexion. Par exemple, un plongeur à base de silicone de couleur blanche remplit bien cette fonction. Il présente l'avantage de d'établir un bon contact avec la face 22 en évitant notamment d'emprisonner des bulles d'air entre le plongeur et la face 22.

Le clavier 10 comprend un circuit imprimé 25 disposé parallèlement au guide d'onde 20 du coté de la face 23. Le circuit imprimé porte un capteur 26 disposé en regard du plongeur 14 sur l'axe 16 et un capteur 27 disposé en regard du plongeur 15 sur l'axe 17. Les capteurs 26 et 27 sont par exemple des photodiodes sensibles à l'onde lumineuse propagée dans la guide d'onde 20. Les capteurs 26 et 27 forment un signal représentatif de l'appui des touches respectives 11 et 12 par un utilisateur. Pour des photodiodes le signal représentatif est électrique et peut être traité par d'autres composants disposés sur le circuit imprimé 25. Le courant issu d'une photodiode peut être traité au moyen d'un convertisseur courant tension suivi d'un amplificateur opérationnel comparant la tension générée par le convertisseur à un seuil. A la sortie de l'amplificateur opérationnel un signal binaire et disponible représentant la détection d'un appui sur la touche pour l'un des niveaux et l'absence d'appui pour l'autre niveau binaire. A titre d'alternative, d'autres types de capteurs peuvent être mis en oeuvre dans le cadre de l'invention, comme par exemple un capteur délivrant un signal optique.

La figure 2 représente une simulation de l'onde rétrodiffusée pour des appuis simultanés sur quatre touches voisines du clavier 10. L'onde rétrodiffusée lors du contact d'un plongeur sur la face 22 est émise autour d'une direction perpendiculaire au plan du guide d'onde 20. Les différents plongeurs sont repérés 35 sur la figure 2. L'intensité de l'onde rétrodiffusée est maximale sur la direction perpendiculaire au plan du guide d'onde 20 et décroit pour des directions s'éloignant de la direction perpendiculaire. Sur la figure 2, des traits représentent la présence d'une onde rétrodiffusée. Plus les trais sont rapprochés, plus l'intensité de l'onde rétrodiffusée est importante. Afin d'éviter que les capteurs 26 et 27 ne détecte une onde rétrodiffusée par un plongeur voisin que ne lui est pas associé, le clavier 10 comprend au moins un cache permettant de protéger le capteur 26 ou 27 d'une onde parasite ne provenant pas de la frustration entrainée par le contact du plongeur associé au capteur. Plusieurs variantes de cache sont représentées sur la figure 1. Le cache peut être formé par un mur 28 disposé sur le circuit imprimé 25 entre les capteurs 26 et 27. Il est également possible de prévoir un mur entourant chacun des capteurs 26 et 27. Le cache peut également être formé par un masque opaque 29 disposé sur la face 23 empêchant une onde rétrodiffusée oblique de sortir du guide d'onde 20. Le masque peut recouvrir l'ensemble de face 23 à l'exception de trous, par exemple circulaires, centrés sur les axes 16 et 17, autrement dit, à l'exception d'un trou si le clavier ne comprend qu'une seule touche ou de plusieurs trous centrés chacun en regard d'une zone destinée à recevoir le contact d'un des plongeurs 14 ou 15 sur la première face 22.

Avantageusement, le guide d'onde 20 peut être utilisé pour rétroéclairer le clavier 10. Cet éclairage peut être mis en oeuvre pour afficher des images, zones de textes ou icones présents entre les touches sur le support 13. Ces images servent par exemple de légende pour les différentes touches du clavier 10. De la lumière extraite du guide d'onde 20 traverse le support 13 qui est transparent ou au moins partiellement transparent. Il est possible d'autoriser à la lumière de traverser le support 13 uniquement dans des zones où les images sont présentes. Hors de ces zones d'images, le support peut être recouvert de peinture opaque, par exemple noire. Le support peut également avoir des propriétés de diffuseur afin de d'homogénéiser la lumière qui le traverse. Il est également possible de rétroéclairer les touches du clavier 10. Pour extraire de la lumière du guide d'onde 20, la face 22 comprend une ou plusieurs zones altérées 37 de façon à ce qu'une partie de l'onde se propageant dans le guide sorte du guide d'onde 20 par la ou les zones altérées 37.

Les zones altérées peuvent être réalisées au moyen d'une peinture diffusante disposée sur la face 22. Avantageusement, les zones altérées comprennent des moyens de focalisation de la lumière extraite par la face 22 autour d'une direction perpendiculaire au plan du guide d'onde 20. Les moyens de focalisation sont par exemple formés par un film micro prisme, bien connu dans la littérature anglo-saxonne sous le nom de BEF pour l'abréviation de Brightness Enhancement Film. Les moyens de focalisation permettent d'éviter que la lumière extraite pour le rétro éclairage du clavier 10 ne perturbe la détection de la frustration par les plongeurs.

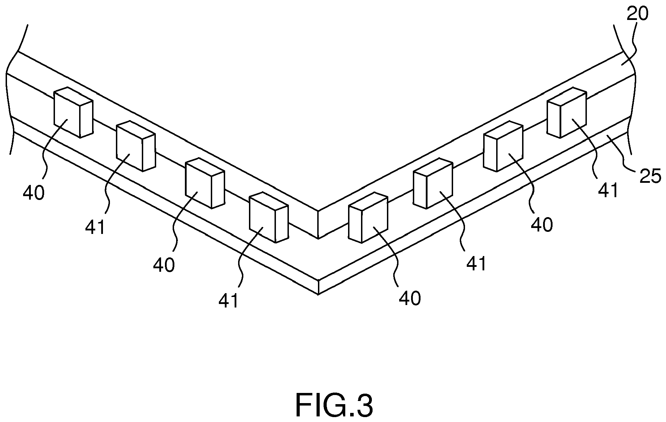

La figure 3 représente schématiquement un clavier 10 en perspective. Sur cette figure sont représentées des sources permettant de générer l'onde propagée dans le guide d'onde 20. Le clavier 10 est plan et s'étend par exemple selon une surface parallélépipédique. Le guide d'onde 20 s'étend sensiblement sur toute la surface du clavier 10. Les sources d'onde se propageant dans le guide d'onde 20 peuvent être formées de diodes électroluminescentes disposées sur le pourtour du guide d'onde 20 et l'éclairant par sa tranche. Les sources peuvent être toutes identiques et n'émettre toutes que sur la même longueur d'onde.

Alternativement, il est possible de différentier les sources en fonction de leur utilisation. Plus précisément, on peut utiliser des sources de longueur d'onde différentes pour la détection de l'appui par les plongeurs et pour le rétro éclairage du clavier 10. Par exemple, on peut mettre en oeuvre des diodes émettant dans une bande infrarouge pour la détection de l'appui des plongeurs et des diodes émettant dans une bande de longueur d'onde visible pour le rétro éclairage. Les deux types de diodes sont par exemple alternés sur le pourtour du guide d'onde. La proportion des diodes émettant dans chacune des bandes est adaptée en fonction du besoin. Ainsi, on réduit le risque d'interférence entre le rétro éclairage et la détection de l'appui par les plongeurs. Les capteurs 26 et 27 sont également adaptés à détecter la bande de longueur d'onde choisie pour les diodes prévues pour la détection de l'appui des plongeurs. Sur la figure 3, des diodes 40 émettent dans l'infrarouge et des diodes 41 émettent dans une bande de longueur visible. Les zones altérées 37 peuvent comprendre un traitement particulier pour limiter la transmission de longueur d'onde choisie pour les diodes prévues pour la détection de l'appui des plongeurs.

On peut avantageusement mettre à profit la présence du guide d'onde pour permettre un retour d'information vers l'utilisateur en fonction du contact d'un des plongeurs sur la face 22. A cet effet, le clavier comprend une source de lumière 45 pilotée par le signal représentatif issu du capteur correspondant. Cette source de lumière 45 est activée en fonction de l'appui par l'utilisateur sur la touche correspondante. Le retour d'information peut être direct, la source de lumière 45 peut être active uniquement en cas d'appui. Le retour d'information peut être indirect par exemple lorsqu'une touche simple effet est utilisée pour piloter un relais. La source de lumière 45 est activée lors d'un premier appui sur la touche activant le relais et désactivé lors d'un appui ultérieur désactivant le relais.

La source de lumière 45 peut être disposée de façon à émettre dans le guide d'onde 20. La source est alors disposée en périphérie du guide d'onde 20 comme les sources 40 et 41. Alternativement, la source de lumière 45 est disposée de façon à émettre de la lumière perpendiculairement au guide d'onde 20 en le traversant. Cette alternative est bien adaptée à un clavier comprenant plusieurs touches et pour lequel on souhaite un retour d'ordre distinct pour chacune des touches. La source de lumière 45 est par exemple formée d'une ou plusieurs diodes électroluminescentes disposées sur le circuit imprimé 25 à proximité du capteur correspondant à la touche pour laquelle on souhaite un retour d'information. Le mur 28 peut séparer la source de lumière 45 du capteur correspondant. Alternativement ou en complément, comme pour la ségrégation entre le rétro éclairage et la détection de l'appui, le capteur peut être insensible à la lumière émise par la source 45. De même, il est possible de différentier la couleur du rétro éclairage de celle du retour d'information. Par exemple le capteur peut travailler dans l'infrarouge, le rétro éclairage dans le rouge et le retour d'information dans le vert. Il est possible de prévoir plusieurs couleurs différentes pour différents retours d'information, pour un clavier 10 à plusieurs touches, ou pour une même touche en fonction de son utilisation.

Un clavier selon l'invention permet de séparer l'action mécanique sur la touche de la détection de cette action mécanique. Physiquement cette séparation est faite par le guide d'onde 20. On peut mettre à profit cette séparation physique pour isoler électro-magnétiquement les touches du clavier 10 et les signaux électriques dévirés par le clavier en fonction d'appuis sur les touches. A cet effet, le clavier 10 comprend un écran de blindage électrique 50 disposé sur une des faces du guide d'onde, l'écran de blindage étant transparent à l'onde (ou aux ondes) propagée(s) dans la guide d'onde 20 et le cas échéant transparent à la lumière utilisée pour le retour d'ordre. L'écran de blindage est par exemple réalisé au moyen d'une électrode conductrice transparente disposée sur l'une des faces 22 et 23. Cette électrode est par exemple réalisée en oxyde d'indium dopé à l'étain bien connu sous le nom d'ITO pour son abréviation anglo-saxonne : Indium tin oxide. D'autres technologies peuvent être mises en oeuvre pour réaliser l'écran de blindage 50, telle que par exemple la mise en oeuvre d'un film transparent incorporant une grille conductrice. Ce type de film est connu dans la littérature anglo-saxonne sous le nom de « micro mesh film ». L'écran de blindage 50 recouvre toute la surface du guide d'onde 20 et est raccordé à une masse électrique du clavier, par exemple par l'intermédiaire du circuit imprimé 25.

## Revendications

1. Clavier (10) comprenant plusieurs touches (11, 12) destinées à être manoeuvrées par un utilisateur, la manoeuvre des touches (11, 12) permettant de former pour chaque touche un signal représentatif de sa manoeuvre, comprenant :
• un guide d'onde plan (20) possédant une première et une seconde faces externes (22, 23), une onde lumineuse pouvant se réfléchir totalement entre les deux faces (22, 23), la première face (22) du guide d'onde (20) comprenant une zone altérée (37) de façon à ce qu'une partie de l'onde sorte du guide d'onde (20) par la zone altérée (37) pour rétroéclairer le clavier,
• pour chaque touche, un plongeur (14, 15, 35) apte à être déplacé par la touche correspondante (11, 12) entre deux positions, l'une en contact avec la première face (22) du guide d'onde (20) et l'autre à distance de la première face (22), le contact du plongeur (14, 15, 35) sur la première face (22) entrainant une frustration locale de la réflexion de l'onde dans le guide d'onde (20),
• sous chacun des plongeurs (14, 15, 35), un capteur (26, 27) disposé dans un espace libre délimité par la seconde face (23), le capteur (26, 27) étant configuré pour détecter la frustration de la réflexion, le capteur (26, 27) formant le signal représentatif respectif.

2. Clavier selon la revendication 1, **caractérisé en ce qu'**il comprend un écran de blindage électrique (50) disposé sur une des faces (22, 23) du guide d'onde (20), l'écran de blindage (50) étant transparent à l'onde propagée dans la guide d'onde (20).

3. Clavier selon l'une des revendications précédentes, **caractérisé en ce qu'**il comprend au moins un cache (28, 29) permettant de protéger chacun des capteurs (26, 27) d'une onde parasite ne provenant pas de la frustration entrainée par le contact du plongeur (14, 15) associé au capteur (26, 27).

4. Clavier selon la revendication 3, **caractérisé en ce que** le cache est formé par un masque (29) opaque à l'onde se propageant dans le guide d'onde (20), le masque recouvrant la seconde face (23) à l'exception d'un trou centré en regard d'une zone (30, 31) destinée à recevoir le contact du plongeur (14, 15) sur la première face (22).

5. Clavier selon l'une des revendications précédentes, **caractérisé en ce que** la zone altérée (37) comprend des moyens de focalisation de la lumière extraite par la première face (22) autour d'une direction perpendiculaire au plan du guide d'onde (20).

6. Clavier selon l'une des revendications précédentes, **caractérisé en ce qu'**il comprend une première et une seconde sources d'onde (40, 41) se propageant dans le guide d'onde (20) et émettant chacune dans une bande de longueur d'onde, les deux bandes étant distinctes, **en ce que** le capteur (26, 27) est configuré pour détecter une onde de la bande de la première source (40) et **en ce que** la bande de la seconde source (41) est utilisée pour sortir du guide d'onde (20) par la zone altérée (37).

7. Clavier selon l'une des revendications précédentes, **caractérisé en ce qu'**il comprend une source de lumière (45) pilotée par le signal représentatif et permettant un retour d'information vers l'utilisateur fonction du contact du plongeur (14, 15, 35) avec la première face (22) du guide d'onde (20).

8. Clavier selon la revendication 7, **caractérisé en ce que** la source de lumière (45) permettant le retour d'information est disposée de façon à émettre de la lumière perpendiculairement au guide d'onde (20) en le traversant.

9. Clavier selon l'une quelconque des revendications 7 ou 8, **caractérisé en ce que** la source de lumière (45) permettant le retour d'information émet dans une bande de longueur d'onde distincte de celle pour laquelle le capteur (26, 27) est configuré.

## Patentansprüche

1. Tastatur (10), die mehrere Tasten (11, 12) umfasst, die vorgesehen sind, durch einen Benutzer betätigt zu werden, wobei die Betätigung der Tasten (11, 12) es erlaubt, für jede Taste ein Signal zu bilden, das repräsentativ für ihre Betätigung ist, umfassend:
• einen planen Wellenleiter (20), der eine erste und eine zweite Außenseite (22, 23) besitzt, wobei eine Lichtwelle sich vollständig zwischen den beiden Seiten (22, 23) reflektieren kann, wobei die erste Seite (22) des Wellenleiters (20) einen veränderten Bereich (37) derart umfasst, dass ein Teil der Welle aus dem Wellenleiter (20) durch den veränderten Bereich (37) austritt, um die Tastatur von hinten zu beleuchten,
• für jede Taste einen Stößel (14, 15, 35) der geeignet ist, durch die entsprechende Taste (11, 12) zwischen zwei Stellungen verlagert zu werden, wobei die eine davon in Kontakt mit der ersten Seite (22) des Wellenleiters (20) und die andere mit Abstand zu der ersten Seite (22) ist, wobei der Kontakt des Stößels (14, 15, 35) auf der ersten Seite (22) eine örtliche Frustration der Reflexion der Welle in dem Wellenleiter (20) verursacht,
• unter jedem der Stößel (14, 15, 35) einen Sensor (26, 27), der in einem durch die zweite Seite (23) begrenzten freien Raum angeordnet ist, wobei der Sensor (26, 27) dafür konfiguriert ist, die Frustration der Reflexion zu erfassen, wobei der Sensor (26, 27) das jeweilige repräsentative Signal bildet.

2. Tastatur nach Anspruch 1, **dadurch gekennzeichnet, dass** sie einen Schirm für elektrische Abschirmung (50) umfasst, der auf einer der Seiten (22, 23) des Wellenleiters (20) angeordnet ist, wobei der Schirm für Abschirmung (50) für die in dem Wellenleiter (20) ausgebreitete Welle durchlässig ist.

3. Tastatur nach einem der vorhergehenden Ansprüche, **dadurch gekennzeichnet, dass** sie mindestens eine Abdeckung (28, 29) umfasst, die erlaubt, jeden der Sensoren (26, 27) vor einer parasitären Welle zu schützen, die nicht von der Frustration stammt, die durch den mit dem Sensor (26, 27) verbundenen Kontakt des Stößels (14, 15) verursacht wird.

4. Tastatur nach Anspruch 3, **dadurch gekennzeichnet, dass** die Abdeckung durch eine für die Welle, die sich in dem Wellenleiter (20) ausbreitet, undurchsichtige Maske (29) gebildet ist, wobei die Maske die zweite Seite (23) mit Ausnahme eines in Bezug auf einen Bereich (30, 31) zentrierten Lochs bedeckt, das vorgesehen ist, den Kontakt des Stößels (14, 15) auf der ersten Seite (22) aufzunehmen.

5. Tastatur nach einem der vorhergehenden Ansprüche, **dadurch gekennzeichnet, dass** der veränderte Bereich (37) Mittel zur Scharfeinstellung des durch die erste Seite (22) extrahierten Lichts rings um eine Richtung senkrecht zur Ebene des Wellenleiters (20) umfasst.

6. Tastatur nach einem der vorhergehenden Ansprüche, **dadurch gekennzeichnet, dass** sie eine erste und eine zweite Quelle von Wellen (40, 41) umfasst, die sich in dem Wellenleiter (20) ausbreiten und jeweils in einem Wellenlängenband abstrahlen, wobei die beiden Bänder unterschiedlich sind, dadurch, dass der Sensor (26, 27) konfiguriert ist, um eine Welle des Bands der ersten Quelle (40) zu erkennen, und dadurch, dass das Band der zweiten Quelle (41) verwendet wird, um durch den veränderten Bereich (37) aus dem Wellenleiter (20) auszutreten.

7. Tastatur nach einem der vorhergehenden Ansprüche, **dadurch gekennzeichnet, dass** sie eine durch das repräsentative Signal gesteuerte Lichtquelle (45) umfasst und erlaubend eine Informationsrückkopplung zu der Benutzer in Abhängigkeit vom Kontakt des Stößels (14, 15, 35) mit der ersten Seite (22) des Wellenleiters (20).

8. Tastatur nach Anspruch 7, **dadurch gekennzeichnet, dass** die Lichtquelle (45), die die Informationsrückkopplung erlaubt, derart angeordnet ist, dass sie Licht rechtwinklig zu dem Wellenleiter (20) abstrahlt, indem es ihn durchläuft.

9. Tastatur nach einem der Ansprüche 7 oder 8, **dadurch gekennzeichnet, dass** die Lichtquelle (45), die die Informationsrückkopplung erlaubt, in einem Wellenlängenband unterschiedlich zu demjenigen abstrahlt, für den der Sensor (26, 27) konfiguriert ist.

## Claims

1. Keyboard (10) comprising several keys (11, 12) intended to be operated by a user, the operating of the keys (11, 12) making it possible to form, for each key, a signal representative of the operation thereof, comprising:
• a planar waveguide (20) having a first and a second external face (22, 23), it being possible for a light wave to reflect totally between the two faces (22, 23), the first face (22) of the waveguide (20) comprising a zone (37) which is altered so that part of the wave leaves the waveguide (20) via the altered zone (37) in order to backlight the keyboard,
• for each key, a plunger (14, 15, 35) which can be moved by the corresponding key (11, 12) between two positions, one in contact with the first face (22) of the waveguide (20) and the other remote from the first face (22), the contact of the plunger (14, 15, 35) with the first face (22) causing the reflection of the wave in the waveguide (20) to be locally frustrated,
• under each of the plungers (14, 15, 35), a sensor (26, 27) arranged in an empty space delimited by the second face (23), the sensor (26, 27) being configured to detect the frustration of the reflection, the sensor (26, 27) forming the respective representative signal.

2. Keyboard according to claim 1, **characterised in that** it comprises an electrical shielding screen (50) arranged on one of the faces (22, 23) of the waveguide (20), the shielding screen (50) being transparent to the wave propagated in the waveguide (20).

3. Keyboard according to either of the preceding claims, **characterised in that** it comprises at least one cover (28, 29) allowing protection of each of the sensors (26, 27) from a parasitic wave not originating from the frustration brought about by the contact of the plunger (14, 15) associated with the sensor (26, 27).

4. Keyboard according to claim 3, **characterized in that** the cover is formed by a mask (29) which is opaque to the wave propagating in the waveguide (20), the mask covering the second face (23) except for a hole centered facing a zone (30, 31) intended to receive the contact of the plunger (14, 15) on the first face (22).

5. Keyboard according to any one of the preceding claims, **characterised in that** the altered zone (37) comprises means for focusing the light extracted via the first face (22) around a direction perpendicular to the plane of the waveguide (20).

6. Keyboard according to any one of the preceding claims, **characterised in that** it comprises a first and a second wave source (40, 41) propagating in the waveguide (20) and each source emitting in a wavelength band, the two bands being distinct, **in that** the sensor (26, 27) is configured to detect a wave of the band of the first source (40), and **in that** the band of the second source (41) is used to leave the waveguide (20) via the altered zone (37).

7. Keyboard according to any one of the preceding claims, **characterised in that** it comprises a light source (45) controlled by the representative signal and allowing information to be fed back to the user as a function of the contact of the plunger (14, 15, 35) with the first face (22) of the waveguide (20).

8. Keyboard according to claim 7, **characterised in that** the light source (45) allowing the feedback of information is arranged in such a manner as to emit light perpendicularly to the waveguide (20) and crossing it.

9. Keyboard according to either claim 7 or 8, **characterized in that** the light source (45) allowing the feedback of information emits in a wavelength band distinct from the one for which the sensor (26, 27) is configured.
